Europäisches Patentamt

European Patent Office

Office européen des brevets

(11) Numéro de publication: **0 317 422**
**A1**

## DEMANDE DE BREVET EUROPEEN

(21) Numéro de dépôt: 88402866.3

(22) Date de dépôt: 15.11.88

(51) Int. Cl.⁴: **H 05 K 3/34**
**B 23 K 3/06**

(30) Priorité: 17.11.87 FR 8715856

(43) Date de publication de la demande:
24.05.89 Bulletin 89/21

(84) Etats contractants désignés: **DE ES NL**

(71) Demandeur: **COMMISSARIAT A L'ENERGIE ATOMIQUE**
**31/33, rue de la Fédération**
**F-75015 Paris (FR)**

(72) Inventeur: **Lochard, Jean-Pierre**
**La Tuilerie**
**F-91530 Saint Cheron (FR)**

(74) Mandataire: **Mongrédien, André et al**
**c/o BREVATOME 25, rue de Ponthieu**
**F-75008 Paris (FR)**

(54) Dispositif individuel d'étamage de circuits imprimés.

(57) L'invention concerne un dispositif individuel d'étamage de circuits imprimés.

Le dispositif comprend un support (10) apte à recevoir un circuit imprimé, une semelle chauffante (20) apte à être appliquée sur ledit circuit et des moyens (30) de contrôle de la température de cette semelle chauffante (20).

Description

## DISPOSITIF INDIVIDUEL D'ETAMAGE DE CIRCUITS IMPRIMES

La présente invention a pour objet un dispositif individuel d'étamage de circuits imprimés.

L'étamage n'est pas qu'une préparation des circuits imprimés à la soudure mais c'est aussi une protection des circuits après réalisation des soudures. C'est pourquoi différents types de dispositifs d'étamage ont été inventés, qui permettent d'étamer une grande quantité de circuits.

Deux principaux types de dispositifs d'étamage sont connus. Le brevet GB-A-841 864 enseigne un procédé pour étamer, où le circuit à traiter est entraîné entre deux rouleaux tournants. Un des rouleau est plongé dans un bain d'étain porté à 240°C. La face à étamer du circuit est au contact de ce rouleau.

Les machines à étamer au rouleau mettant en oeuvre ce procédé sont décrites dans la fiche technique n° 8610 du catalogue de la société Ingelor par exemple. Ces machines présentent de nombreux inconvénients elles sont longues à mettre en route ; lors du passage du circuit entre les rouleaux, le cuivre du circuit peut se décoller ; l'étain du bain, laissé à l'air libre, s'oxyde ; de plus ces machines sont d'un prix élevé.

Les machines à étamer à la vague sont plus fiables que les machines à étamer au rouleau. Les circuits défilent sur des rubans porteurs. La face à étamer reçoit un jet (vague) d'étain.

Ces différentes machines à étamer sont conçues pour une utilisation quotidienne et intensive. De grandes quantités d'étain sont nécessaires à leur fonctionnement, ce qui entraîne des temps de chauffe et de mise en route longs, des risques de perte du bain d'étain par oxydation et finalement des prix élevés, à l'achat, mais aussi de fonctionnement. Ces machines ne sont pas rentables dans le cadre d'un petit laboratoire qui a besoin d'une machine à étamer pratique et simple d'emploi, de mise en route rapide et qui ne soit pas d'un coût élevé. La présente invention répond à ces critères elle permet une utilisation individuelle et économique.

De manière plus précise, la présente invention a pour objet un dispositif individuel d'étamage de circuits imprimés. Elle est caractérisée en ce qu'elle comprend :
- un support apte à recevoir un circuit imprimé,
- une semelle chauffante apte à être appliquée sur un circuit imprimé, munie d'une poignée, et reliée à une alimentation électrique.
- des moyens de contrôle de la température de la semelle reliés d'une part à la semelle et d'autre part à l'alimentation électrique.

Selon un mode de réalisation préféré, le support est incliné.

Selon un mode de réalisation préféré, le support est muni de deux butées. l'une fixe, l'autre mobile.

Selon un mode de réalisation préféré, les moyens de contrôle de la température de la semelle chauffante comprennent :
- une sonde de température solidaire de la semelle chauffante, - des moyens pour déconnecter l'alimentation électrique de la semelle chauffante.

Ces moyens permettent d'éviter un échauffement trop fort de la semelle qui serait défavorable au bon fonctionnement du dispositif.

Selon un mode de réalisation préféré, la semelle chauffante est en cuivre ou en alliage de cuivre. Ces matériaux sont de bons conducteurs thermiques et ils ne craignent pas le contact avec les métaux d'apport utilisés lors de l'étamage. Ils conviennent donc parfaitement à un dispositif d'étamage.

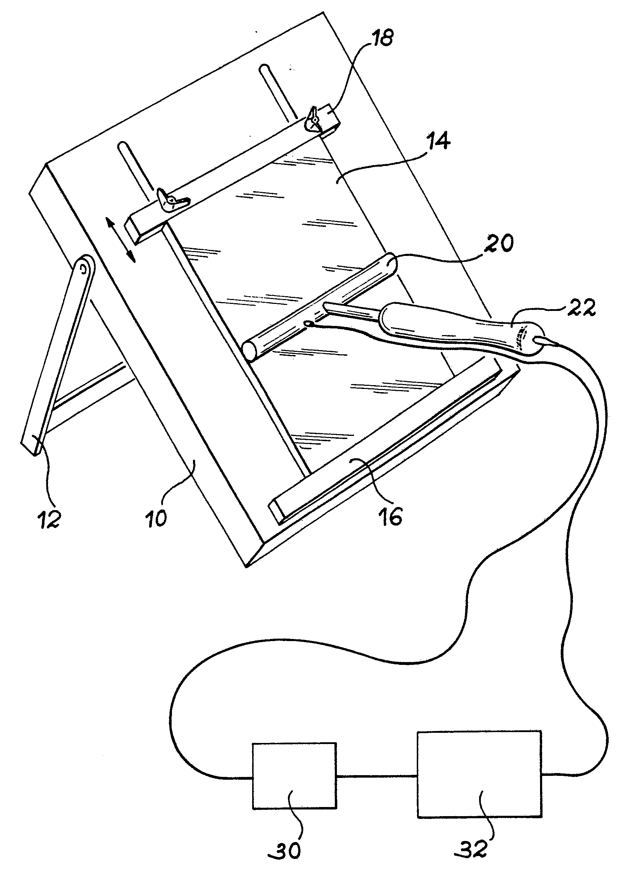

D'autres caractéristiques et avantages de l'invention ressortiront mieux de la description qui va suivre, donnée à titre purement illustratif et nullement limitatif, en référence à la figure annexée qui représente schématiquement le dispositif selon l'invention.

Le dispositif est constitué d'un support 10 apte à recevoir un circuit imprimé 14. Le support est incliné : il repose sur un pied 12. Il est muni de deux butées, l'une inférieure 16 fixe, l'autre supérieure 18 mobile. Le dispositif comprend une semelle chauffante 20, apte à être appliquée sur un circuit imprimé 14, munie d'une poignée 22 et reliée à une alimentation électrique 32. En dernier lieu, le dispositif comprend des moyens 30 de contrôle de la température de la semelle 20, moyens qui sont reliés d'une part à la semelle 20 et d'autre part à l'alimentation électrique. La semelle chauffante 20 est portée à une température d'environ 220°C, température d'utilisation du métal d'apport à l'étain qui peut être de la marque Castotin n° 1, commercialisé par la Société française de Térotechnologie, par exemple.

Une fois la température de 220°C atteinte, les moyens 30 coupent l'alimentation électrique de la semelle chauffante 20. La semelle 20 enduite dudit métal d'apport est appliquée, dans un mouvement de haut en bas, sur ledit circuit imprimé 14.

## Revendications

1. Dispositif individuel d'étamage des circuits imprimés, caractérisé en ce qu'il comprend :
- un support (10) apte à recevoir un circuit imprimé (14),
- une semelle chauffante (20) apte à être appliquée sur un circuit imprimé (14), munie d'une poignée (22), et reliée à une alimentation électrique (32),
- des moyens (30) de contrôle de la température de la semelle (20) reliés d'une part à la semelle (20) et d'autre part à l'alimentation électrique (32).

2. Dispositif selon la revendication 1, caractérisé en ce que le support (10) est incliné.

3. Dispositif selon la revendication 1, caractérisé en ce que le support (10) est muni de deux butées (16, 18).

4. Dispositif selon la revendication 3, caractérisé en ce que l'une (16) des butées est fixe, l'autre (18) est mobile.

5. Dispositif selon la revendication 1, caractérisé par le fait que les moyens (30) de contrôle de la température de la semelle (20) comprennent :

- une sonde de température solidaire de la semelle (20),

- des moyens pour déconnecter l'alimentation électrique (32) de la semelle chauffante (20).

6. Dispositif selon la revendication 1, caractérisé en ce que la semelle chauffante (20) est en cuivre ou en alliage de cuivre.

EP 0 317 422 A1

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | DE-B-1 300 761 (SIEMENS AG) --- | | H 05 K 3/34 B 23 K 3/06 |
| A,D | GB-A- 841 864 (PHILIPS ELECTRICAL INDUSTRIES) --- | | |
| A | US-A-2 821 959 (BELL TELEPHONE LABORATORIES INC.) --- | | |
| A | FR-A-2 172 153 (GLAVERBEL-MECANIVER) ----- | | |

**DOMAINES TECHNIQUES RECHERCHES (Int. Cl.4)**

H 05 K
B 23 K

**Le présent rapport a été établi pour toutes les revendications**

| Lieu de la recherche | Date d'achèvement de la recherche | Examinateur |
|---|---|---|
| LA HAYE | 22-02-1989 | SCHUERMANS N.F.G. |